# EUROPEAN PATENT SPECIFICATION

(11) **EP 2 472 610 B1**
(45) Date of publication and mention of the grant of the patent: **14.02.2018**
(21) Application number: 11171724.5
(22) Date of filing: 28.06.2011
(51) Int. Cl.: H01L 33/58, H01L 33/00, H01L 33/54, H01L 33/50, H01L 25/075, H01L 33/56

(54) **LIGHT EMITTING DIODE PACKAGE AND METHOD FOR MANUFACTURING SAME**
GEHÄUSE FÜR LICHTEMITTIERENDE HALBLEITERVORRICHTUNG UND HERSTELLUNGSVERFAHREN DAVON
BOÎTIER-PUCE DE DIODE ÉLECTROLUMINESCENTE ET SON PROCÉDÉ DE FABRICATION

(30) Priority: 31.12.2010 TW 099147331
(43) Date of publication of application: 04.07.2012
(73) Proprietor: InterLight Optotech Corporation, Yangmei City, Taoyuan County 32661 (TW)
(72) Inventor: Liu, Hong-Zhi, 32661 Taoyuang (TW)
(74) Representative: Ter Meer Steinmeister & Partner

(56) References cited:
- EP-A1- 1 953 834
- EP-A2- 1 657 758
- WO-A1-2008/149256
- WO-A1-2011/101764
- JP-B2- 2 900 000
- TW-A- 201 037 865
- US-A1- 2007 228 390
- US-A1- 2010 109 025
- US-A1- 2010 123 855

## Description

### FIELD OF THE INVENTION

The invention relates generally to a light emitting diode (LED) device and a method for manufacturing the same, and more particularly, relates to a LED package utilizing an in-mold decoration film and a method for manufacturing the same.

### BACKGROUND OF THE INVENTION

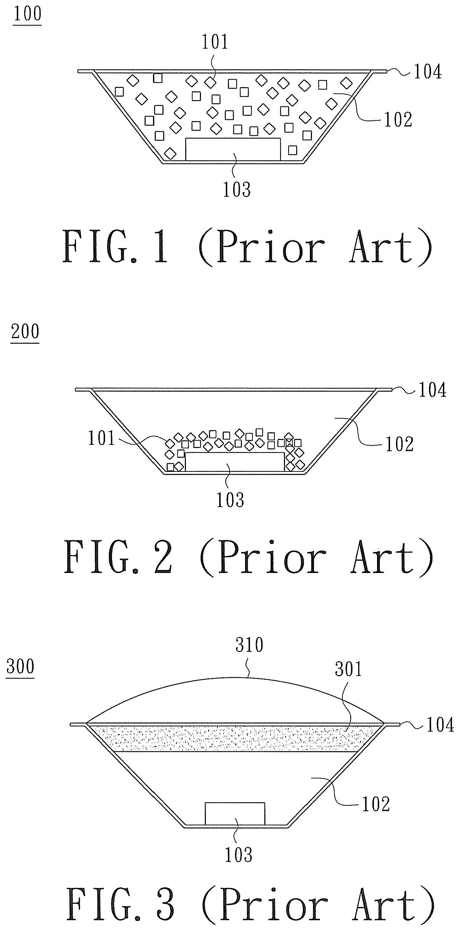

As energy-saving issue has been getting more and more attentions, LED illumination has become one of the popular lighting applications now. FIG.s 1 to 3 are schematic views respectively illustrating three conventional LED packages packaged by different method. FIG. 1 illustrates a LED package 100 packaged by a traditional uniform distribution method.

As shown in FIG. 1, the phosphor 101 (including red, green or yellow phosphor) packaged by a traditional uniform distribution method seems can be uniformly distributed in a molding compound 102 molded on a substrate 104. However, as the distribution of the phosphor 101 can not be controlled very uniformly, it is difficult for the traditional method to make an LED package 100 having high color uniformity and high outputting lumen. To solve these problems, an electrophoresis coating technique is utilized to distribute the phosphor 101 around the LED die 103 in order to form a conformal distribution structure having uniform thickness on the surface of the LED die 103.

FIG. 2 illustrates a LED package 200 packaged by the aforementioned conformal distribution method. The advantage of using the conformal distribution method to coat the phosphor 101 is that the conformal distribution structure can convert the blue excitation light of the phosphor 101 into white light with great uniformity; thus this excellent color controlling ability may benefit the performance of the LED package 200.

However, the manufacturing cost of the electrophoresis coating technique is too high to satisfy the demand of reducing the selling price of the LED package 200. Moreover, because the phosphor 101 of the conformal structure may directly congregate on the surface of the LED die 103, the light absorption of the phosphor 101 per unit area is low. In addition, since the phosphor 101 is separated far away from the light emitting surface of the LED package 200, the excitation light of yellow or green phosphor may be easily absorbed by the red phosphor before emitting out of the light emitting surface, such that the light extraction efficiency of LED package 200 may be reduced.

To improve the light extraction efficiency of a LED package, a remote phosphor configuration technique is currently employed to coat the phosphor 101. FIG. 3 illustrates a LED package 300 packaged by the remote phosphor configuration technique in accordance with the prior art. The remote phosphor configuration technique includes coating a phosphor layer 301 on the molded molding compound 102 of the LED package 300; thus the phosphor layer 301 is separated away from the LED die 103 for a spatial separation rather than being direct in contact with the LED die 103. Because, this spatial separation can reduce the re-absorption phenomenon of the emitted light of the LED die 103 and avoid the degradation of the phosphor 301 resulted from the high temperature of the LED die 103, such that the light extraction efficiency and reliability of the LED package 300 can be significantly improved.

Besides, to improve the luminous flux of the LED package 300, a lens 310 is usually assembled on to the packaged LED package. However, the process for fabricating this structure which includes packaging a LED die 103 by a molding compound 102; forming a phosphor layer 301 on the surface of the molding compound 102 and disposing the lens 310 on the phosphor layer 301 may require two or more molding processes in the manufacturing process and make the manufacturing procedures more complex. Thus, it is difficult to reduce the manufacturing cost of the LED package 300.

In view of the foregoing situations, it is desirous to provide an improved LED package and a method for manufacturing the same in order to simplify the manufacturing process and greatly reduce the manufacturing cost without deteriorating the light extraction efficiency and the reliability of the LED package.

WO 2011/101764 A1 published after the filing date of the present application discloses a light emitting device with molded phosphor layer, wherein the flexible film comprising a phosphor material is positioned over a light source like a light emitting diode mounted on a support substrate. The diode is aligned with an indentation in the mold such that the flexible film is disposed between the support substrate and the mold. Transparent molding material is disposed between the support substrate and the mold. The support substrate and the mold are pressed together to fill the indentation. The flexible film conforms to the shape of the light source or the mold.

EP 1 953 834 A1 discloses a light emitting device including an LED chip, a mounting substrate carrying the LED chip, a dome shaped color conversion member and an encapsulation member. The color conversion member is molded from a transparent resin material and a fluorescent material which is excited by light emitted from the LED chip to emit a light of a color different from a luminescent color of the LED chip, and is adhered to the mounting substrate to surround the LED chip. The encapsulation member is made of an encapsulation material to encapsulate the LED chip and bonding wires within a space confined between a mounting board and the color conversion member. The encapsulation member is of a convex shape to have its light output surface kept in an intimate contact with an internal surface of the color conversion member.

US 2010/0109025 A1 discloses an over the mold phosphor lens for an LED, wherein rectangular LED dice are mounted on a submount wafer. A first mold has rectangular indentations in it generally corresponding to the positions of the LED dice. The indentations are filled with silicone, which when cured forms a clear first lens over each LED. Since the wafer is precisely aligned with the mold, the tops surfaces of the first lenses are all within a single reference plane. A second mold has rectangular indentations filled with a phosphor-infused silicone so as to form a precisely defined phosphor layer over the clear first lens. A third mold forms an outer silicone lens.

WO 2008/149256 A1 discloses a self-supporting luminescent film and phosphor-enhanced illumination system. The self-supporting luminescent film comprises luminescent particles and an organic polymer. The luminescent particles comprise luminescent material which is arranged for absorbing at least part of the impinging light, impinging on the luminescent particles and for converting the absorbed light into converted light. The organic polymer interconnects the luminescent particles to form the self-supporting luminescent film. TW201037865 A discloses a light emitting module and manufacturing method thereof.

US20100123855 A1 discloses a light emitting module comprising a board, a plurality of light emitting devices on the board, and a phosphor film covering the light emitting devices and covering and extending along the areas between the light emitting devices.

JP2900000 B2 discloses a light emitting display and the manufacturing method thereof.

### SUMMARY OF THE INVENTION

One aspect of the invention is to provide a LED package as defined in claim 1.

In another embodiment of the invention, the lens consists of a transparent molding compound. In some embodiments of the invention, the transparent molding compound is formed by curing epoxy resin or silica gel. In another embodiment, the lens has a convex cambered surface.

In another embodiment of the invention, the surface treatment layer is a silica gel layer, an epoxy resin layer or other transparent material that can resist moisture and oxygen.

The invention also provides a method for manufacturing a LED package according to claim 6.

In another embodiment of the invention, the in-mold decoration film further comprises a carrier layer, a releasing film disposed on the carrier layer, wherein the surface treatment layer disposed on the releasing film and the phosphor layer disposed on the surface treatment layer. In an embodiment of the invention, the in-mold decoration film further comprises an adhesive layer disposed on the phosphor layer.

In another embodiment of the invention, the method further comprises a step of stripping the releasing film to separate the carrier layer from the surface treatment layer after the formation of the lens.

In another embodiment of the invention, the transparent molding compound is epoxy resin or silica gel.

In accordance with aforementioned embodiments of the invention, a LED package and a method for manufacturing the same are provided, wherein an in-mold decoration film having a phosphor layer and a surface treatment layer is utilized as an outer film to package a LED die. It means that only one molding process is required; nevertheless, an improved optical performance similar to that provided by a conventional LED package having a remote phosphor configuration structure can still be accomplished. Besides, a lens structure which can improve the light flux of the LED package is also provided by the same approach. In other words, while maintaining the light extraction efficiency and the reliability as the conventional LED package did, the embodiments of the invention can not only simplify the traditional LED packaging process but can also reduce the manufacturing cost significantly.

### BRIEF DESCRIPTION OF THE DRAWINGS

The above objects and advantages of the invention will become more readily apparent to those ordinarily skilled in the art after reviewing the following detailed description and accompanying drawings, in which:
FIG. 1 illustrates a LED package packaged by a traditional uniform distribution method.;
FIG. 2 illustrates schematic view of a LED package packaged by a conformal distribution phosphor method in accordance with the prior art.
FIG. 3 illustrates a LED package packaged by a remote phosphor configuration technique in accordance with the prior art.
Figs. 4A to 4F illustrate cross sectional views of the processing structures for manufacturing a LED package in accordance with one embodiment of the invention; and
FIG. 4G illustrates an enlarged cross sectional view of the LED package structure shown in FIG. 4F.

### DETAILED DESCRIPTION OF PREFERRED EMBODIMENTS

The invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

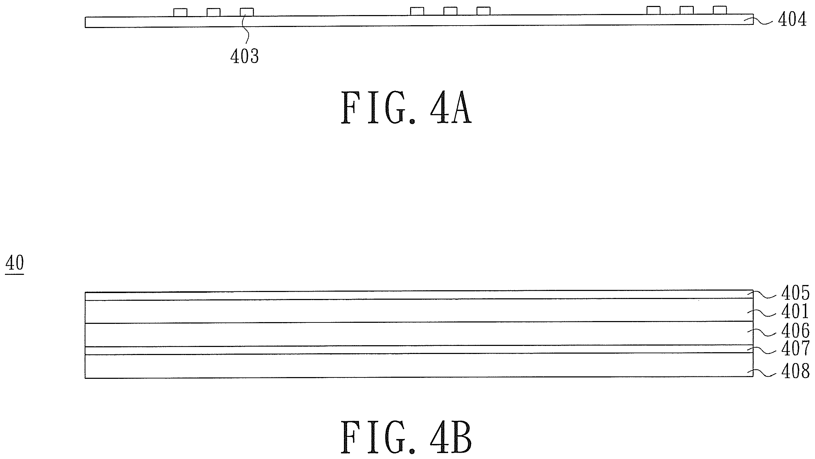

The invention provides a LED package and a method for manufacturing the same. Figs. 4A to 4F illustrate cross sectional views of the processing structures for manufacturing a LED package 400 in accordance with one embodiment of the invention. The method comprises steps as follows. As shown in Fig. 4A, a substrate 404 is firstly provided wherein more than one LED dies 403 are fixed onto the substrate 404.

Also, a flexible in-mold decoration film 40 comprising a phosphor layer 401 and a surface treatment layer 406 is provided. In the embodiment, the in-mold decoration film 40 further comprises a carrier layer 408, a releasing film 407 and an adhesive layer 405, wherein the releasing film 407 is disposed on the carrier layer 408; the surfaced treated layer 406 is disposed on the releasing film; the phosphor layer 401 is disposed on the surface treatment layer 406; and an adhesive layer 405 is disposed on the phosphor layer 401 (shown in Fig. 4B).

The carrier layer 408 can be a flexible plastic substrate, e.g. a substrate consisting of polyethylene terephthalate (PET) or other polymeric materials with the likely characteristics. The releasing film 407 is preferably consisting of polysiloxane. While the releasing film 407 is subjected to stress, heat or light, the carrier layer 408 can be separated from the in-mold decoration film 40. The surface treatment layer 406 possesses the characteristics of scratchproof, waterproof and moisture proof. In some embodiments, the surface treatment layer 406 can be a silica gel layer or an epoxy resin layer. The phosphor layer 401 preferably is formed by steps of mixing phosphor and adhesive and then coating the mixture onto the carrier layer 408. In some embodiments, the phosphor layer 401 is a thin visible-light excitation layer printed or coated on the carrier layer 408.

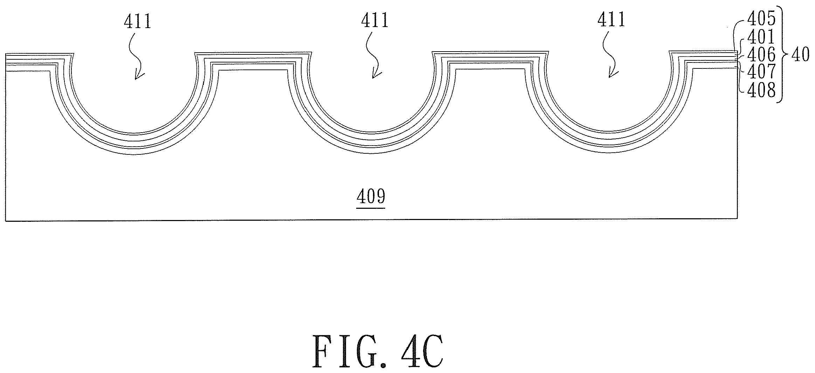

Subsequently, the in-mold decoration film 40 is deformed to define a plurality of recesses 411 using the surface treatment layer 406 serves as an outer wall of the recesses 411. In some embodiments, the deformation of the in-mold decoration film 40 comprises stamping the in-mold decoration film 40 with a stamping die 409. In the embodiment, the in-mold decoration film 40 is deformed by a vacuum lamination process to make the in-mold decoration film 40 conforming to the stamping die 409 (as shown in FIG. 4C). In an embodiment of, the stamping die 409 has a plurality of recesses and each of which has a cambered surface; thus each of the recesses 411 defined on the deformed in-mold decoration film 40 and conforming to the stamping die 409 has a concave cambered surface.

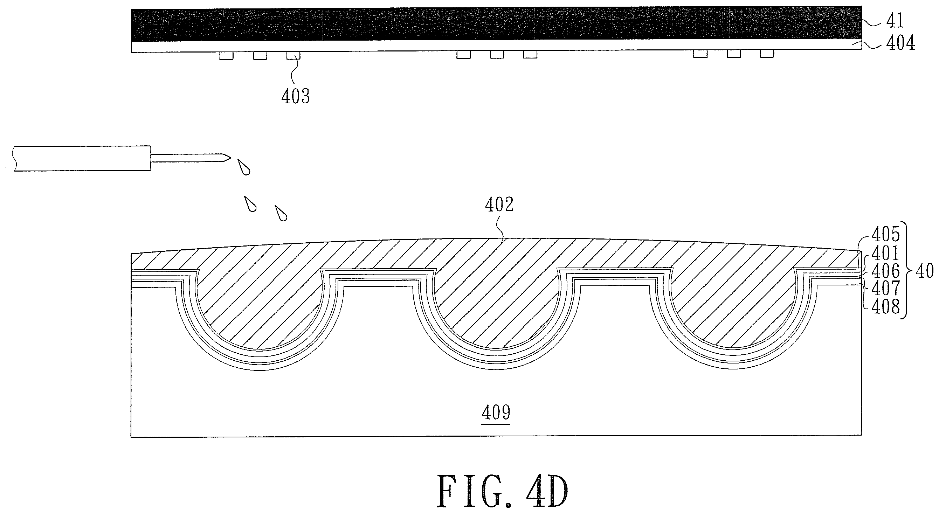

Next, the recesses 411 are filled with a transparent molding compound 402 (as shown in Fig. 4D). In some embodiments of the invention, the transparent molding compound 402 consists of melted epoxy resin. However, the high operating temperature of LED die 409 may trigger the epoxy resin undergoing deterioration, such as yellowing, and so as to lead the emitted light of the LED package 400 attenuated. Therefore, in the some preferred embodiments, melted epoxy resin can be substituted with silica gel which possesses characteristics of high reflectivity, heat-resistance, good insulation, chemical stability, high light transmittance (for the light in the wavelength range from 300 to 700 nm), and high reliability serves as the transparent molding compound 402.

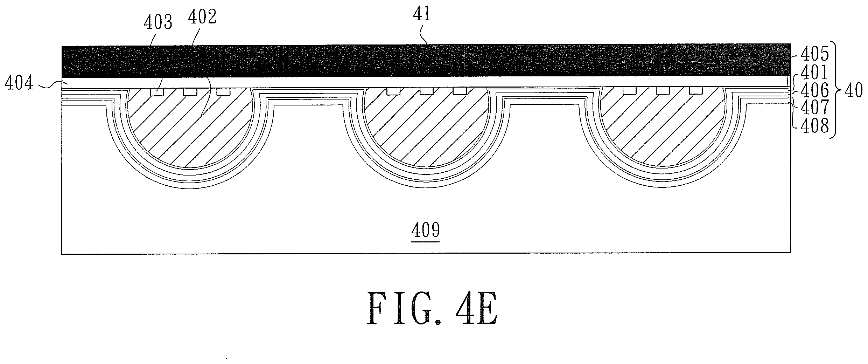

Thereafter, the substrate 404 and the in-mold decoration film 40 are assembled to make each of the LED dies 403 disposed in one of the recesses 411 and encapsulated in the transparent molding compound 402(as shown in Fig. 4E). In the embodiment, to assemble the substrate 404 and the in-mold decoration film 40, the substrate 404 having the LED dies 403 fixed thereon is sucked by a tool 41 (as shown in Fig. 4D), and then is pressed onto the deformed in-mold decoration film 40 which is carried by the stamping die 409 and contains the transparent molding compound 402. In some embodiments, each of the LED dies 403 is corresponding to one of the recesses, thus each recess may be allocated one or more LED dies 403 according to the design of the LED package 400.

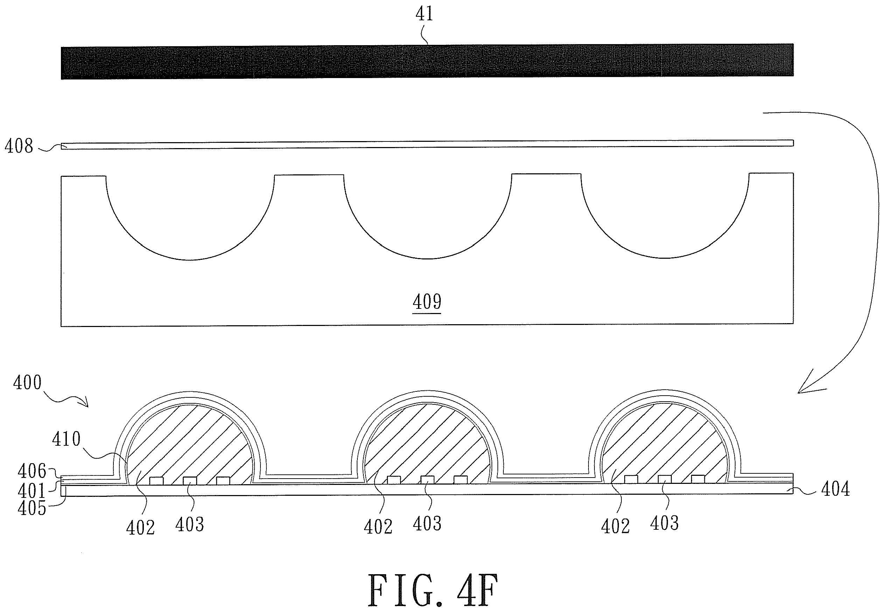

After the transparent molding compound 402 is cured to form a lens 410, the assembled substrate 404 and the in-mold decoration film 40 are then released from the stamping die 409, and the carrier layer 408 is separated from the in-mold decoration film 40 by stress, heat or light to form a plurality of LED package 400 as shown in Fig. 4F.

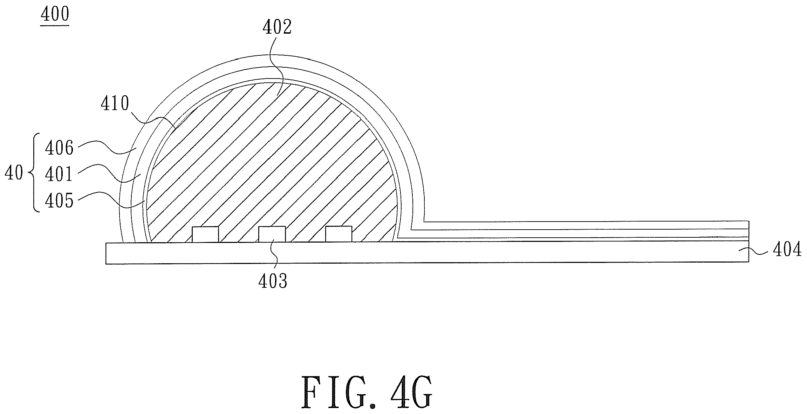

FIG. 4G illustrates an enlarged cross sectional view of the LED package 400 structure shown in FIG. 4F. Referring to FIG. 4F, the LED package 400 comprises a substrate 404 having at least one LED die 403 fixed thereon; a lens 410 consisting of cured transparent molding compound 402 molded on the substrate 404 in order to encapsulate the LED die 403; and an in-mold decoration film 40 comprising a phosphor layer 401 disposed on the lens 410; and a surface treatment layer 406 disposed on the phosphor layer 401.

In the preferable embodiment, the surface treatment layer 406 is a silica gel layer; the phosphor layer 401 is a thin phosphor coating layer. Additionally, in an embodiment, an adhesive layer 405 is disposed between the phosphor layer 401 and the lens 410. The transparent molding compound 402 which is cured to form the lens 410 can be silica gel.

In accordance with aforementioned embodiments, a LED package and a method for manufacturing the same are provided. In the embodiments, an in-mold decoration film having an adhesive layer, a phosphor layer and a surface treatment layer is utilized as an outer film to package a LED die, wherein the surface treatment layer is deformed to identify at least one recess using the surface treatment layer serves as an outer wall of the recess; and the recess is then filled with a transparent molding compound which can be cured to form a lens after the substrate is assembled with the in-mold decoration film to dispose the LED die in the recess, thereby the LED die fixed on the substrate can be capsulated in the lens by merely single one molding process.

In other words, an improved optical performance similar to that provided by a conventional LED package having a remote phosphor configuration structure can be accomplished by the embodiments of the invention; nevertheless, merely one molding process is required. Besides, a lens structure which can improve the light flux of the LED package is also provided by the same approach. Therefore, while maintaining the light extraction efficiency and the reliability as the conventional LED package did, the embodiments not only can simplify the traditional LED packaging process but also can reduce the manufacturing cost significantly. In summary a light emitting diode (LED) package and the manufacturing method thereof are provided. The LED package 400 comprises a substrate 404, at least one LED die 403, a lens 410 and an in-mold decoration film 40, wherein the LED die 403 is fixed on the substrate 404; the lens 410 is convexly molded on the substrate 404 to encapsulate the LED die 403; and the in-mold decoration film 40 has an adhesive layer 405, at least one phosphor layer 401 disposed on the lens 410 and a surface treatment layer 406 disposed on the phosphor layer 401.

## Claims

1. A light emitting diode package (400), comprising:
- a substrate (404);
- a light emitting diode (LED) die (403) fixed on the substrate (404); and
- a lens (410) convexly molded on the substrate (404) to encapsulate the LED die (403); **characterized in that** the light emitting diode package (400) further comprises
- an in-mold decoration film (40) having a phosphor layer (401), a surface treatment layer (406) disposed on the phosphor layer (401) and an adhesive layer (405) disposed under the phosphor layer (401), wherein a first portion of the in-mold decoration film (40) contacts the lens (410) and a second portion of the in-mold decoration film (40) extends to a position beyond the lens (410).

2. The LED package of claim 1, wherein the lens (410) consists of a transparent molding compound (402).

3. The LED package of claim 1 or 2, wherein the transparent molding compound (402) is an epoxy resin or a silica gel.

4. The LED package of one of the preceding claims, wherein the lens (410) comprises a convex cambered surface.

5. The LED package of one of the preceding claims, wherein the surface treatment layer (406) is a silica gel layer or an epoxy resin layer.

6. A method for manufacturing an LED package (400), comprising:
- providing a substrate (404) having an LED die (403) fixed thereon;
- providing an in-mold decoration film (40) having a phosphor layer (401), disposed on a surface treatment layer (406) and an adhesive layer (405) disposed on the phosphor layer (401);
- deforming the in-mold decoration film (40) to define a recess (411) using the surface treatment layer (406) serves as an outer wall;
- filling the recess (411) with a transparent molding compound (402);
- assembling the substrate (404) and the in-mold decoration film (40) to make the LED die (403) be disposed in the recess (411) and encapsulated in the transparent molding compound (402); and
- curing the transparent molding compound (402) to from a lens (410),
wherein a first portion of the in-mold decoration film (40) contacts the lens (410) and a second portion of the in-mold decoration film (40) extends to a position beyond the lens (410).

7. The method for manufacturing the LED package of claim 6, wherein the in-mold decoration film (40) further comprises a carrier layer (408) and a releasing film (407) formed on the carrier layer (408), wherein the surface treatment layer (406) is disposed on the releasing film (407), the phosphor layer (401) is disposed on the surface treatment layer (406).

8. The method for manufacturing the LED package of claim 7, further comprising stripping the releasing film (407) to separate the carrier layer (408) from the surface treatment layer (406) after forming the lens (410).

9. The method for manufacturing the LED package of one of claims 6 to 8, wherein the transparent molding compound (402) is an epoxy resin or a silica gel.

## Patentansprüche

1. Gehäuse für lichtemittierende Halbleitervorrichtung (400), umfassend:
- ein Substrat (404);
- einen Chip (403) für lichtemittierende Halbleitervorrichtungen (LED), der auf dem Substrat (404) befestigt ist; und
- eine Linse (410), die konvex auf das Substrat (404) geformt ist, um den LED-Chip (403) zu kapseln;
**dadurch gekennzeichnet, dass** das Gehäuse für lichtemittierende Halbleitervorrichtung (400) ferner umfasst
- eine Folie (40) zur Dekoration in der Form mit einer Phosphorschicht (401), eine Oberflächenbehandlungsschicht (406) die auf der Phosphorschicht (401) angeordnet ist, und eine Kleberschicht (405) die unter der Phosphorschicht (401) angeordnet ist, wobei ein erster Abschnitt der Folie (40) zur Dekoration in der Form mit der Linse (410) in Kontakt steht und sich ein zweiter Abschnitt der Folie (40) zur Dekoration in der Form zu einer Position jenseits der Linse (410) erstreckt.

2. LED-Gehäuse nach Anspruch 1, wobei die Linse (410) aus einer transparenten Formmasse (402) besteht.

3. LED-Gehäuse nach Anspruch 1 oder 2, wobei die transparente Formmasse (402) ein Epoxidharz oder ein Silikagel ist.

4. LED-Gehäuse nach einem der vorhergehenden Ansprüche, wobei die Linse (410) eine konvexe gekrümmte Oberfläche umfasst.

5. LED-Gehäuse nach einem der vorhergehenden Ansprüche, wobei die Oberflächenbehandlungsschicht (406) eine Silikagel-Schicht oder eine Epoxidharz-Schicht ist.

6. Verfahren zur Herstellung eines LED-Gehäuses (400), umfassend:
- Bereitstellen eines Substrats (404) mit einem LED-Chip (403), der daran befestigt ist;
- Bereitstellen einer Folie (40) zur Dekoration in der Form mit einer Phosphorschicht (401), die auf einer Oberflächenbehandlungsschicht (406) angeordnet ist, und einer Kleberschicht (405), die auf der Phosphorschicht (401) angeordnet ist;
- Verformen der Folie (40) zur Dekoration in der Form, um eine Aussparung (411) mittels der Oberflächenbehandlungsschicht (406) zu definieren dient als Außenwand;
- Füllen der Aussparung (411) mit einer transparenten Formmasse (402);
- Zusammenfügen des Substrats (404) und der Folie (40) zur Dekoration in der Form, damit der LED-Chip (403) in der Aussparung (411) angeordnet und in der transparenten Formmasse (402) gekapselt ist; und
- Aushärten der transparenten Formmasse (402), um eine Linse (410) zu bilden, wobei ein erster Abschnitt der Folie (40) zur Dekoration in der Form mit der Linse (410) in Kontakt steht und sich ein zweiter Abschnitt der Folie (40) zur Dekoration in der Form zu einer Position jenseits der Linse (410) erstreckt.

7. Verfahren zur Herstellung des LED-Gehäuses nach Anspruch 6, wobei die Folie (40) zur Dekoration in der Form ferner eine Trägerschicht (408) und eine Trennfolie (407) umfasst, die auf der Trägerschicht (408) gebildet ist, wobei die Oberflächenbehandlungsschicht (406) auf der Trennfolie (407) angeordnet ist, die Phosphorschicht (401) auf der Oberflächenbehandlungsschicht (406) angeordnet ist.

8. Verfahren zur Herstellung des LED-Gehäuses nach Anspruch 7, ferner umfassend Abziehen der Trennfolie (407), um nach dem Bilden der Linse (410) die Trägerschicht (408) von der Oberflächenbehandlungsschicht (406) zu trennen.

9. Verfahren zur Herstellung des LED-Gehäuses nach Anspruch 6 bis 8, wobei die transparente Formmasse (402) ein Epoxidharz oder ein Silikagel ist.

## Revendications

1. Conditionnement de diode électroluminescente (400), comprenant :
- un substrat (404) ;
- une matrice de diode électroluminescente (DEL) (403) fixée sur le substrat (404) ; et
- une lentille (410) moulée de façon convexe sur le substrat (404) pour encapsuler la matrice de DEL (403) ;
**caractérisé en ce que** le conditionnement de diode électroluminescente (400) comprend en outre :
- un film de décoration moulé à l'intérieur (40) ayant une couche de substance fluorescente (401), une couche de traitement de surface (406) disposée sur la couche de substance fluorescente (401) et une couche adhésive (405) disposée sous la couche de substance fluorescente (401), dans lequel une première partie du film de décoration moulé à l'intérieur (40) entre en contact avec la lentille (410) et une deuxième partie du film de décoration moulé à l'intérieur (40) s'étend vers une position au-delà de la lentille (410).

2. Conditionnement de DEL selon la revendication 1, dans lequel la lentille (410) est constituée d'un mélange à mouler transparent (402).

3. Conditionnement de DEL selon la revendication 1 ou 2, dans lequel le mélange à mouler transparent (402) est une résine époxy ou un gel de silice.

4. Conditionnement de DEL selon l'une des revendications précédentes, dans lequel la lentille (410) comprend une surface bombée convexe.

5. Conditionnement de DEL selon l'une des revendications précédentes, dans lequel la couche de traitement de surface (406) est une couche de gel de silice ou une couche de résine époxy.

6. Procédé de fabrication d'un conditionnement de DEL (400), comprenant :
- la fourniture d'un substrat (404) ayant une matrice de DEL (403) fixée dessus ;
- la fourniture d'un film de décoration moulé à l'intérieur (40) ayant une couche de substance fluorescente (401) disposée sur une couche de traitement de surface (406) et une couche adhésive (405) disposée sur la couche de substance fluorescente (401) ;
- la déformation du film de décoration moulé à l'intérieur (40) pour définir un creux (411) en utilisant la couche de traitement de surface (406) servant de paroi extérieure ;
- le remplissage du creux (411) avec un mélange à mouler transparent(402) ;
- l'assemblage du substrat (404) et du film de décoration moulé à l'intérieur (40) pour faire en sorte que la matrice de DEL (403) soit disposée dans le creux (411) et encapsulée dans le mélange à mouler transparent (402) ; et
- le traitement du mélange à mouler transparent (402) pour former une lentille (410),
dans lequel une première partie du film de décoration moulé à l'intérieur (40) entre en contact avec la lentille (410) et une deuxième partie du film de décoration moulé à l'intérieur (40) s'étend vers une position au-delà de la lentille (410).

7. Procédé de fabrication du conditionnement de DEL selon la revendication 6, dans lequel le film de décoration moulé à l'intérieur (40) comprend en outre une couche porteuse (408) et un film de démoulage (407) formé sur la couche porteuse (408), dans lequel la couche de traitement de surface (406) est disposée sur le film de démoulage (407), la couche de substance fluorescente (401) est disposée sur la couche de traitement de surface (406).

8. Procédé de fabrication du conditionnement de DEL selon la revendication 7, comprenant en outre l'élimination du film de démoulage (407) pour séparer la couche porteuse (408) de la couche de traitement de surface (406) après la formation de la lentille (410).

9. Procédé de fabrication du conditionnement de DEL selon l'une des revendications 6 à 8, dans lequel le mélange à mouler transparent (402) est une résine époxy ou un gel de silice.
